# EUROPEAN PATENT APPLICATION

(11) **EP 2 669 987 A1**
(43) Date of publication of application: **04.12.2013**
(21) Application number: 11856727.0
(22) Date of filing: 24.01.2011
(51) Int. Cl.: H01M 10/42

(54) **POWER STORAGE SYSTEM**

(71) Applicant: Toyota Jidosha Kabushiki Kaisha, Toyota-shi, Aichi 471-8571 (JP)
(72) Inventor: ICHIKAWA, Koichi, Toyota-shi Aichi 471-8571 (JP)
(74) Representative: Intès, Didier Gérard André
(86) International application number: PCT/JP2011/000351
(87) International publication number: WO 2012/101667

(57) **Abstract**

[PROBLEM] The deterioration state of an electric storage apparatus may be changed depending on the usage environment of the electric storage apparatus.

[SOLVING MEANS] An electric storage system includes an electric storage apparatus (10) connected to a load and performing charge and discharge, a temperature sensor (12) detecting the temperature of the electric storage apparatus in response to connection of the electric storage apparatus to the load, and a controller (30) estimating the deterioration state of the electric storage apparatus based on temperature information in a usage environment of the electric storage apparatus. The controller obtains a temperature distribution of the electric storage apparatus based on an output from the temperature sensor when the electric storage apparatus is connected to the load, and specifies a usage environment of the electric storage apparatus associated with the obtained temperature distribution.

## Description

### [TECHNICAL FIELD]

The present invention relates to an electric storage system in which the deterioration state of an electric storage apparatus is estimated in view of the usage environment of the electric storage apparatus.

### [BACKGROUND ART]

There is a technology in which the deterioration state of an assembled battery is estimated by detecting the temperature of the assembled battery with a temperature sensor (see, for example, Patent Document 1). When the assembled battery is mounted on a vehicle, the temperature detection with the temperature sensor is performed at the time of switching of an ignition switch of the vehicle from OFF to ON.

### [PRIOR ART DOCUMENT]

### [PATENT DOCUMENTS]

[Patent Document 1] Japanese Patent Laid-Open No. 2007-074891
[Patent Document 2] Japanese Patent Laid-Open No. 2010-045901
[Patent Document 3] Japanese Patent Laid-Open No. 2002-157361
[Patent Document 4] Japanese Patent Laid-Open No. 2010-139396
[Patent Document 5] Japanese Patent Laid-Open No. 2003-047110
[Patent Document 6] Japanese Patent Laid-Open No. 2008-126788

### [SUMMARY OF THE INVENTION]

### [PROBLEMS TO BE SOLVED BY THE INVENTION]

While the ignition switch is OFF, that is, while the vehicle is left standing, the temperature detection with the temperature sensor is not performed. The deterioration state of the assembled battery is also changed according to the temperature of the assembled battery in the period while the vehicle is left standing. The temperature of the assembled battery in the period while the vehicle is left standing depends on the usage environment (temperature) of the assembled battery. Thus, the usage environment of the assembled battery needs to be considered in order to estimate the deterioration state of the assembled battery.

### [MEANS FOR SOLVING THE PROBLEMS]

According to a first aspect, the present invention provides an electric storage system including an electric storage apparatus connected to a load and performing charge and discharge, a temperature sensor detecting the temperature of the electric storage apparatus in response to connection of the electric storage apparatus to the load, and a controller estimating the deterioration state of the electric storage apparatus based on temperature information in a usage environment of the electric storage apparatus. The controller obtains a temperature distribution of the electric storage apparatus based on an output from the temperature sensor when the electric storage apparatus is connected to the load, and specifies a usage environment of the electric storage apparatus associated with the obtained temperature distribution. The temperature distribution of the electric storage apparatus can show the relationship between the temperature of the electric storage apparatus and the frequency of occurrence of each temperature of the electric storage apparatus.

The controller can specify the usage environment of the electric storage apparatus by specifying a temperature distribution matching the temperature distribution obtained from the output of the temperature sensor, out of temperature distributions of the electric storage apparatus in a plurality of usage environments. When the temperature distributions of the electric storage apparatus in the plurality of usage environments are previously prepared, the temperature distribution matching the temperature distribution obtained from the output of the temperature sensor can be specified from the prepared temperature distributions. The specification of the temperature distribution allows specification of the usage environment of the electric storage apparatus. The matching of the temperature distributions includes the case where the two temperature distributions are coincident and the case where the two temperature distributions are not coincident but change similarly.

A current sensor detecting an electric current in charge and discharge of the electric storage apparatus can be provided. The controller can specify the temperature distribution of the electric storage apparatus in the plurality of usage environments in association with the result of detection by the current sensor. Since the current in charge and discharge may change the temperature distribution of the electric storage apparatus, the temperature distribution of the electric storage apparatus in the plurality of usage environments can be specified for each current load of the electric storage apparatus.

The temperature distribution of the electric storage apparatus in the plurality of usage environments can be stored in a memory for each result of detection by the current sensor. With the use of information stored in the memory, the temperature distribution of the electric storage apparatus in the plurality of usage environments can be specified in association with a particular current load.

The controller can estimate the lifetime of the electric storage apparatus as the deterioration state. The controller can impose a restriction on the input/output of the electric storage apparatus when an estimated lifetime of the electric storage apparatus is shorter than a target lifetime. This can suppress the deterioration of the electric storage apparatus to extend the lifetime of the electric storage apparatus. On the other hand, the controller can relax the restriction on the input/output of the electric storage apparatus when the estimated lifetime of the electric storage apparatus is longer than the target lifetime. This can increase the input/output of the electric storage apparatus.

The electric storage apparatus can be formed of a plurality of electric storage elements connected electrically in series. The electric storage apparatus may include a plurality of electric storage elements connected electrically in parallel. The electric storage apparatus can be mounted on a vehicle. The vehicle can be run by converting an electric energy output from the electric storage apparatus into a kinetic energy. A kinetic energy produced in braking of the vehicle can be converted into an electric energy which can be stored in the electric storage apparatus.

According to a second aspect, the present invention provides a method of estimation including a first step of detecting the temperature of an electric storage apparatus in response to connection of the electric storage apparatus to a load, the electric storage apparatus performing charge and discharge, and a second step of obtaining a temperature distribution of the electric storage apparatus based on the result of the detection at the first step provided when the electric storage apparatus is connected to the load and specifying a usage environment of the electric storage apparatus associated with the obtained temperature distribution, and a third step of estimating the deterioration state of the electric storage apparatus based on temperature information in the usage environment of the electric storage apparatus specified at the second step. The temperature distribution of the electric storage apparatus can show the relationship between the temperature of the electric storage apparatus and the frequency of occurrence of each temperature of the electric storage apparatus.

### [ADVANTAGE OF THE INVENTION]

According to the present invention, the usage environment of the electric storage apparatus is specified on the basis of the temperature distribution of the electric storage apparatus obtained from the output of the temperature sensor, so that the deterioration state of the electric storage apparatus can be estimated in view of the usage environment of the electric storage apparatus.

### [BRIEF DESCRIPTION OF THE DRAWINGS]

[Fig. 1] A block diagram showing a driving system for a vehicle.
[Fig. 2] A flow chart showing processing of obtaining temperature information and current information in Embodiment 1.
[Fig. 3] A flow chart showing processing of estimating a battery lifetime and controlling the input/output of an assembled battery in Embodiment 1.
[Fig. 4] A table showing a correspondence between current loads and temperature distributions.
[Fig. 5] A graph showing temperature distributions in four areas at a particular current load.
[Fig. 6] A diagram showing threshold values for use in input/output control of the assembled battery.
[Fig. 7] A flow chart showing processing of estimating a battery lifetime and controlling the input/output of an assembled battery in Embodiment 2.

### [EMBODIMENTS OF THE INVENTION]

Embodiments of the present invention will hereinafter be described.

### [Embodiment 1]

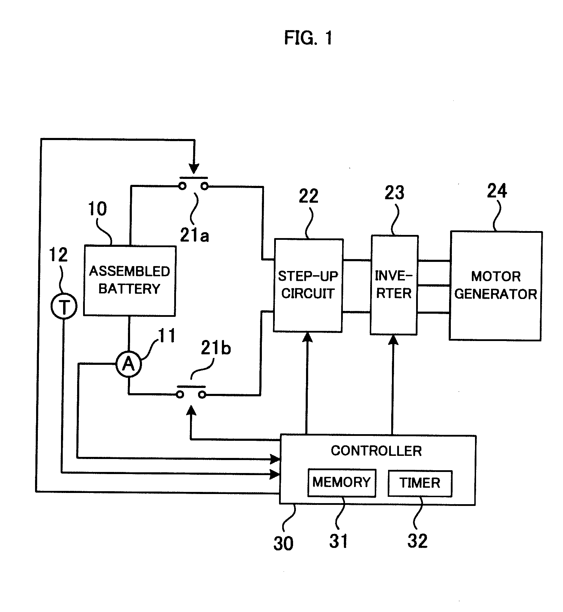

Fig. 1 is a block diagram showing a driving system mounted on a vehicle. Examples of the vehicle in the present embodiment include an electric vehicle and a hybrid vehicle. The electric vehicle includes only an assembled battery as the power source for running of the vehicle. The hybrid vehicle includes not only the assembled battery but also another power source such as an internal-combustion engine or a fuel cell as the power source for the vehicle.

An assembled battery 10 has a plurality of cells connected electrically in series. The number of the cells can be set as appropriate based on the required output of the assembled battery 10 and the like. The assembled battery 10 may include a plurality of cells connected electrically in parallel. A secondary battery such as a nickel metal hydride battery or a lithium-ion battery can be used as the cell. Instead of the secondary battery, an electric double layer capacitor can be used.

A current sensor 11 detects an electric current in charge and discharge of the assembled battery 10 and outputs the detection result to a controller 30. A temperature sensor 12 detects the temperature of the assembled battery 10 and outputs the detection result to the controller 30. The temperature sensor 12 can be attached to one or more of the plurality of cells constituting the assembled battery 10.

The number of the temperature sensors 12 can be set as appropriate. The temperature sensors 12 can be placed at different positions of the assembled battery 10. When the plurality of temperature sensors 12 are used, the temperature detected by a particular one of the temperature sensors 12 can be used as the temperature of the assembled battery 10, or the average value of the temperatures detected by the plurality of temperature sensors 12 can be used as the temperature of the assembled battery 10.

The assembled battery 10 is connected to a step-up circuit 22 through system main relays 21a and 21b. Each of the system main relays 21a and 21b is switched between ON and OFF in response to a control signal from the controller 30. When the system main relays 21a and 21b are switched from OFF to ON, the assembled battery 10 can be charged and discharged.

The step-up circuit 22 increases an output voltage of the assembled battery 10 and supplies the increased voltage to an inverter 23. The step-up circuit 22 reduces a voltage from the inverter 23 and supplies the reduced voltage to the assembled battery 10. The controller 30 controls the operation of the step-up circuit 22. Although the step-up circuit 22 is used in the present embodiment, the step-up circuit 22 can be omitted.

The inverter 23 converts a DC power from the step-up circuit 22 into an AC power and supplies the AC power to a motor generator 24. A three-phase AC motor can be used as the motor generator 24. The inverter 23 converts an AC power from the motor generator 24 into a DC power and supplies the DC power to the step-up circuit 22. The controller 30 controls the operation of the inverter 23. Although the inverter 23 is provided since the AC motor is used as the motor generator 24 in the present embodiment, the inverter 23 can be omitted when a DC motor is used.

The motor generator 24 receives a power from the inverter 23 to generate a kinetic energy for running of the vehicle. The motor generator 24 is coupled to wheels through a power transfer mechanism, and the kinetic energy generated by the motor generator 24 is transferred to the wheels. For decelerating or stopping the vehicle, the motor generator 24 converts a kinetic energy produced in breaking of the vehicle into an electric energy. The electric energy generated by the motor generator 24 can be stored as regenerative power in the assembled battery 10.

The controller 30 has a memory 31 storing predetermined information and a timer 32 used for measuring time. Although the controller 30 contains the memory 31 and the timer 32 in the present embodiment, the memory 31 and the timer 32 may be provided outside the controller 30 instead.

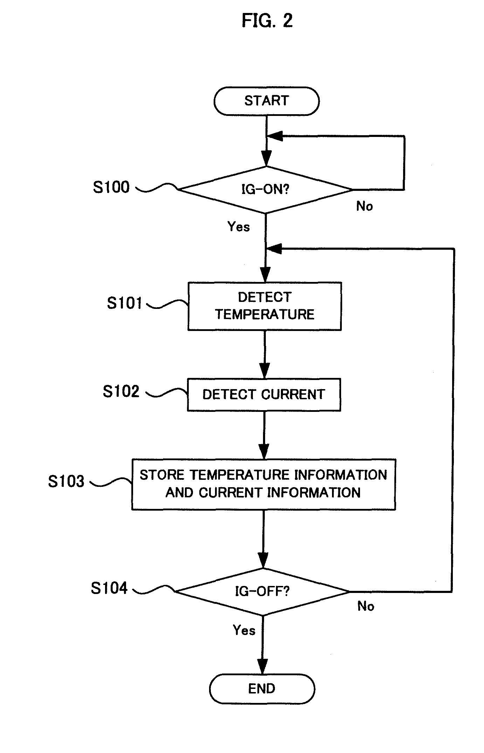

Fig. 2 is a flow chart showing control in running of the vehicle. Processing shown in Fig. 2 is performed by the controller 30.

At step S100, the controller 30 stands by until an ignition switch of the vehicle is switched from OFF to ON. When the ignition switch is switched from OFF to ON, the controller 30 switches the system main relays 21a and 21b from OFF to ON. At step S101, the controller 30 detects the temperature of the assembled battery 10 based on the output from the temperature sensor 12. The switching of the system main relays 21a and 21b from OFF to ON causes the temperature sensor 12 to start the detection operation.

At step S102, the controller 30 detects the electric current in charge and discharge of the assembled battery 10 based on the output from the current sensor 11. For example, the assembled battery 10 is discharged for starting the running of the vehicle or accelerating the vehicle, and the assembled battery 10 is charged for decelerating or stopping the vehicle. The output from the current sensor 11 is changed according to the running pattern of the vehicle.

At step S103, the controller 30 stores the temperature information detected at step S101 and the current information detected at step S102 in the memory 31. The temperature information indicates the relationship between the temperature of the assembled battery 10 and the time while each particular temperature occurs. The current information indicates the change of the electric current over time. The time in each of the temperature information and the current information can be measured by the timer 32.

At step S104, the controller 30 determines whether or not the ignition switch is OFF. When the ignition switch remains ON, the controller 30 returns to the processing at step S101. When the ignition switch is switched from ON to OFF, the present processing is ended.

The processing shown in Fig. 2 can be performed to obtain the temperature information and the current information of the assembled battery 10. The temperature detected by the temperature sensor 12 at the time of the switching of the ignition switch from OFF to ON corresponds to the temperature of the assembled battery 10 in the period while the vehicle is left standing.

During the running of the vehicle, the temperature of the assembled battery 10 is increased with charge and discharge of the assembled battery 10. When the vehicle is stopped (left standing), the charge and discharge of the assembled battery 10 are stopped, and the temperature of the assembled battery 10 starts to drop. The degree of the temperature drop in the assembled battery 10 depends on the temperature in the usage environment of the assembled battery 10. As the vehicle is left standing for a longer time, the temperature of the assembled battery 10 is less likely to change. When the ignition switch is again switched from OFF to ON, the temperature of the assembled battery 10 can be detected with the temperature sensor 12 to obtain the temperature of the assembled battery 10 in the period while the vehicle is stopped.

It is known that the deterioration of the assembled battery 10 depends on the temperature of the assembled battery 10. The temperature of the assembled battery 10 includes the temperature in the period while the vehicle runs, that is, the temperature in the period while the assembled battery 10 is charged and discharged, and the temperature in the period while the vehicle is stopped (left standing), that is, the temperature in the period while the charge and discharge of the assembled battery 10 are inhibited.

As described above, the temperature of the assembled battery 10 in the period while the vehicle is left standing can be obtained by detecting the temperature of the assembled battery 10 with the temperature sensor 12 at the time of the switching of the ignition switch from OFF to ON. In addition, the temperature of the assembled battery 10 in the period while the vehicle runs can be obtained on the basis of the output from the temperature sensor 12 in the period while the ignition switch is ON.

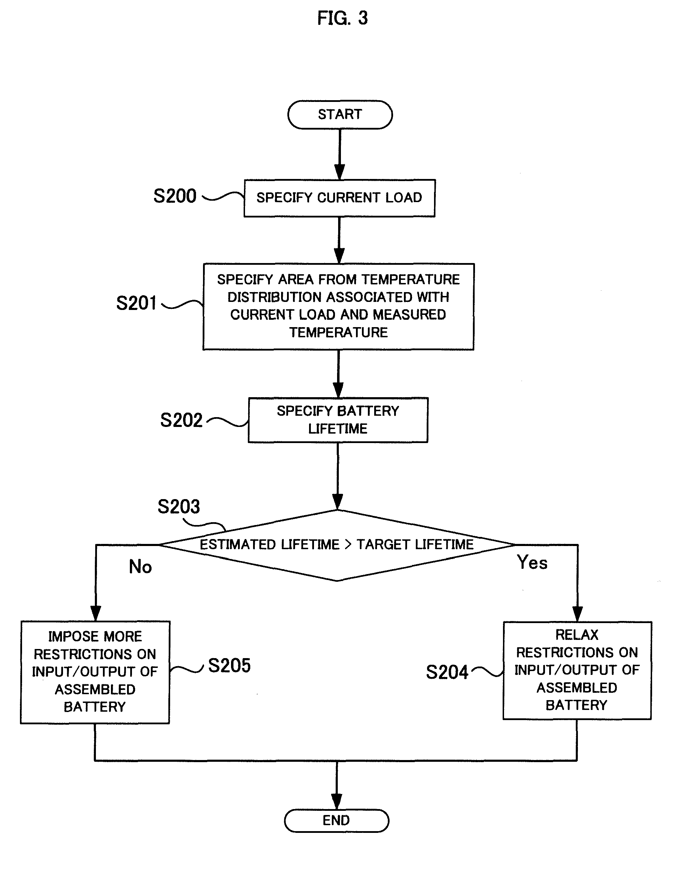

In the present embodiment, the lifetime of the assembled battery 10 is estimated on the basis of the temperature history of the assembled battery 10. Fig. 3 is a flow chart showing processing of estimating the lifetime of the assembled battery 10 and controlling the input/output of the assembled battery 10. The processing shown in Fig. 3 is performed by the controller 30.

At step S200, the controller 30 specifies a current load in the assembled battery 10. The current load can be represented as the square of the electric current and can be specified on the basis of the current information stored in the memory 31 at step S103 in Fig. 2. The current load can be used as information for specifying the running state of the vehicle. Since the current load changes depending on the running state of the vehicle, the specification of the current load allows the running state of the vehicle to be specified.

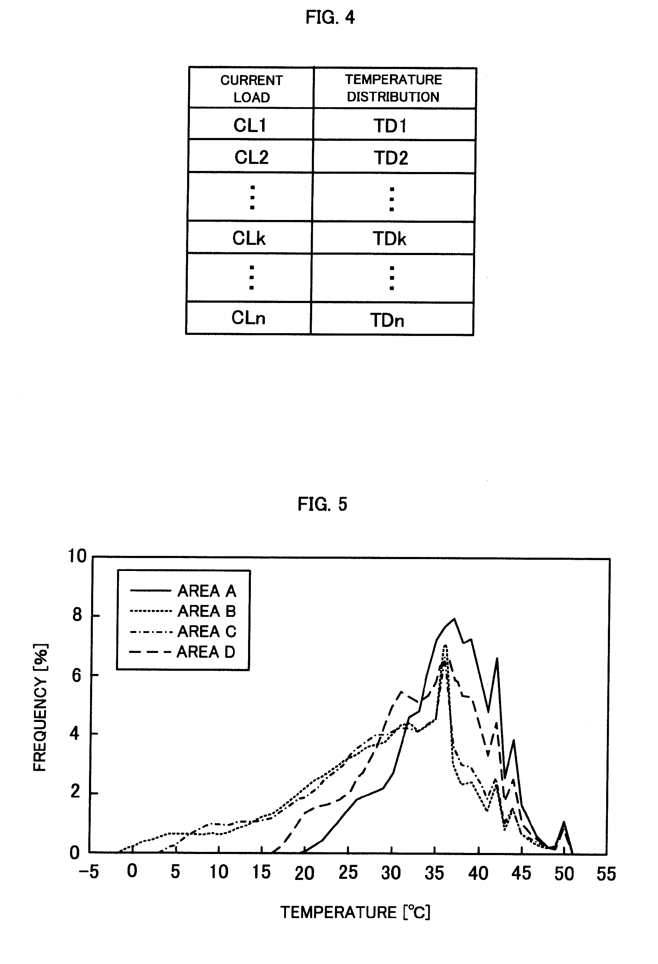

At step S201, the controller 30 specifies the area where the vehicle runs (corresponding to the usage environment) based on a temperature distribution associated with the current load specified at step S200 and the temperature information stored in the memory 31 (steps S101 and S103 in Fig. 2). As shown in Fig. 4, the memory 31 stores data representing the correspondence between current loads CL1 to CLn and temperature distributions TD1 to TDn. The correspondence between the current loads CL1 to CLn and the temperature distributions TD1 to TDn can be previously obtained through actual measurement.

Different current loads mean different charge and discharge states of the assembled battery 10 and different temperature distributions of the assembled battery 10. Thus, the temperature distributions TD1 to TDn associated with the current loads CL1 to CLn need to be obtained previously.

The processing at step S200 can specify the one of the current loads CL1 to CLn that is related to the actual running state of the vehicle. The temperature distribution associated with each of the current loads CL1 to CLn is represented as temperature distributions shown in Fig. 5.

Fig. 5 shows the temperature distribution associated with a particular current load. Fig. 5 shows the temperature distribution of the assembled battery 10 when the vehicle is run in a particular running state (current load) in four areas A to D. In Fig. 5, the horizontal axis represents the temperature of the assembled battery 10 and the vertical axis represents the frequency. The frequency refers to the proportion of a time period in which a particular temperature occurs in the total time period.

As shown in Fig. 5, the temperatures of the assembled battery 10 change similarly at higher temperature levels regardless of the areas A to D. On the other hand, at lower temperature levels of the assembled battery 10, the temperature distributions greatly vary among the areas A to D. The temperature of the assembled battery 10 at the lower temperature levels corresponds to the temperature of the assembled battery 10 in the period while the vehicle is left standing. Thus, when the temperature distribution of the assembled battery 10 immediately after the assembled battery 10 is left standing is obtained, the area (one of the areas A to D) where the vehicle runs can be specified with reference to the temperature distributions shown in Fig. 5.

When the temperature distribution in one of the areas A to D is coincident with the temperature distribution obtained in the processing of Fig. 2, the controller 30 can specify the area having that temperature distribution. When none of the temperature distributions are coincident with the temperature distribution obtained in the processing of Fig. 2, the controller 30 can specify the one of the temperature distributions in the areas A to D that is closest to the temperature distribution obtained in the processing of Fig. 2. The determination of whether or not the temperature distributions are coincident with each other can be performed by comparing the temperature distributions at the lower temperature levels described above.

Although Fig. 5 shows the temperature distributions in the four areas A to D, the number of areas for showing the temperature distributions can be set as appropriate. Temperature distributions may be obtained in any number of areas which have easily distinguishable temperature distributions at lower temperature levels.

Although the temperature distributions TD1 to TDn associated with the current loads CL1 to CLn are specified in the present embodiment, the present invention is not limited thereto. Specifically, it is possible to omit the specification of the current load and to specify the one of a plurality of temperature distributions prepared previously that is coincident with the temperature distribution obtained in the processing of Fig. 2 regardless of the current load, thereby specifying the area.

At step S202, the controller 30 specifies (estimates) the lifetime of the assembled battery 10 based on the temperature distribution in the area specified at step S201. The lifetime of the assembled battery 10 means the period to the point in time when the deterioration state of the assembled battery 10 reaches the state in which the charge and discharge of the assembled battery 10 are inhibited. The deterioration state of the assembled battery 10 can be represented by the change rate of the resistance of the assembled battery 10, for example. The resistance of the assembled battery 10 can be calculated by detecting the voltage and the current of the assembled battery 10. The state in which the charge and discharge of the assembled battery 10 are inhibited can be set as appropriate.

The correspondence between the temperature distribution of the assembled battery 10 and the lifetime of the assembled battery 10 can be previously determined by experiment, and the data representing the correspondence can be stored in the memory 31. With the use of the correspondence between the temperature distribution and the lifetime, the lifetime of the assembled battery 10 can be specified on the basis of the temperature distribution in the area specified at step S201. The lifetime of the assembled battery 10 can also be calculated on the basis of a calculation expression in which the temperature distribution of the assembled battery 10 is used as a parameter.

At step S203, the controller 30 determines whether or not the lifetime (estimated lifetime) of the assembled battery 10 estimated at step S202 is longer than a target lifetime. The target lifetime refers to the lifetime of the assembled battery 10 that is sought, and can be set as appropriate. When the estimated lifetime of the assembled battery 10 is longer than the target lifetime, the controller 30 proceeds to step S204, and when not, the controller 30 proceeds to step S205.

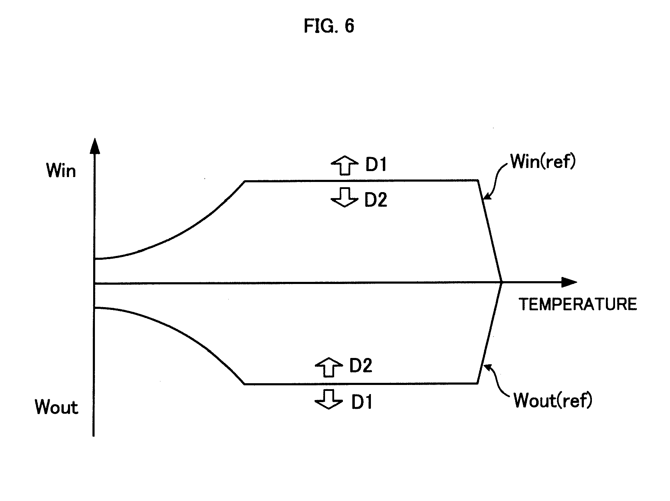

At step S204, the controller 30 relaxes restrictions on the input/output of the assembled battery 10. The input/output (charge and discharge) of the assembled battery 10 is controlled on the basis of threshold values Win(ref) and Wout(ref) shown in Fig. 6. Specifically, the controller 30 controls the charge and discharge of the assembled battery 10 such that the input/output of the assembled battery 10 does not exceed the corresponding threshold value Win(ref) or Wout(ref).

In Fig. 6, the horizontal axis represents the temperature of the assembled battery 10, and the vertical axis represents the input/output of the assembled battery 10. An input Win of the assembled battery 10 corresponds to charge of the assembled battery 10, and an output Wout of the assembled battery 10 corresponds to discharge of the assembled battery 10. The threshold values Win(ref) and Wout(ref) shown in Fig. 6 are illustrative, and the present invention is not limited thereto.

The controller 30 relaxes the restrictions on the input/output of the assembled battery 10 to shift the threshold values Win(ref) and Wout(ref) in directions indicated by arrows D1. The amounts of the shift of the threshold values Win(ref) and Wout (ref) in the directions of the arrows D1 can be identical to or different from each other. The relaxation of the restrictions on the input/output of the assembled battery 10 can increase the power in charge and discharge of the assembled battery 10. When a hybrid vehicle is used as the vehicle, the assembled battery 10 can be used preferentially to improve the fuel efficiency.

At step S205, the controller 30 imposes more restrictions on input/output of the assembled battery 10. Specifically, the controller 30 shifts the threshold values Win(ref) and Wout(ref) shown in Fig. 6 in directions indicated by arrows D2. The amounts of the shift of the threshold values Win(ref) and Wout(ref) in the directions of the arrows D2 can be identical to or different from each other. The imposition of more restrictions on the input/output of the assembled battery 10 can limit the power in charge and discharge of the assembled battery 10. The limit of the input/output of the assembled battery 10 can suppress the deterioration of the assembled battery 10.

When the hybrid vehicle is used as the vehicle, the input/output of the assembled battery 10 may be inhibited at step S205. Even when the input/output of the assembled battery 10 is inhibited, the vehicle can be run by the other power source.

According to the present embodiment, the temperature distribution for each area shown in Fig. 5 can be compared with the temperature distribution obtained from the output of the temperature sensor 12 to specify the area where the assembled battery 10 is used. Once the use area can be specified, the deterioration state of the assembled battery 10 can be estimated in view of the temperature distribution in the use area. The temperature distribution in the use area mainly influences the temperature of the assembled battery 10 in the period while the vehicle is left standing, and the deterioration state of the assembled battery 10 also depends on the temperature of the assembled battery 10 in the period while the vehicle is left standing. Thus, the accuracy in estimating the deterioration state of the assembled battery 10 can be improved by considering the temperature distribution in the use area.

### [Embodiment 2]

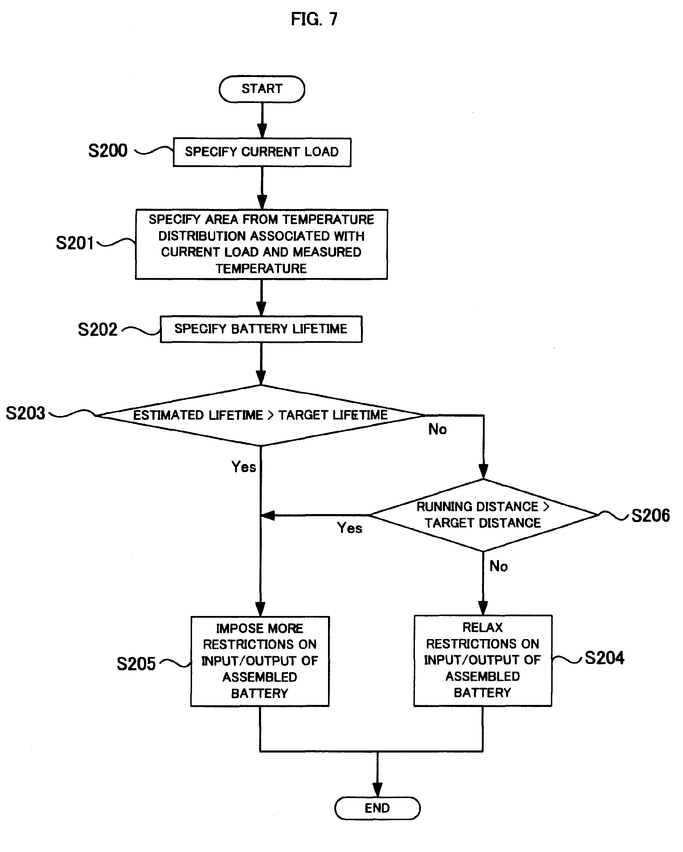

Embodiment 2 of the present invention will be described with reference to Fig. 7. Fig. 7 is a flow chart showing processing of estimating the lifetime of an assembled battery 10 and controlling the input/output of the assembled battery 10. In the present embodiment, the same components as those described in Embodiment 1 are designated with the same reference numerals. The processing shown in Fig. 7 is performed by a controller 30.

In Embodiment 1, the restrictions on the input/output of the assembled battery 10 are added or the restrictions on the input/output are relaxed depending on whether or not the estimated lifetime of the assembled battery 10 is longer than the target lifetime. In the present embodiment, the restrictions on the input/output of the assembled battery 10 are added or the restrictions on the input/output are relaxed by determining not only whether or not the estimated lifetime of the assembled battery 10 is longer than the target lifetime but also whether or not the running distance of a vehicle is longer than a target distance. Specific description is made in the following.

In Fig. 7, processing operations from step S200 to step S205 are identical to those described in Embodiment 1 (Fig. 3). In the present embodiment, at step S203, the controller 30 proceeds to step S205 when the estimated lifetime of the assembled battery 10 is longer than the target lifetime, or when not, the controller 30 proceeds to step S206.

At step S206, the controller 30 determines whether or not the running distance of the vehicle is longer than the target distance. The controller 30 can obtain the running distance of the vehicle with a running distance meter. When the running distance is longer than the target distance, the controller 30 performs processing at step S205. When the running distance is not longer than the target distance, the controller 30 performs processing at step S204.

### [Embodiment 3]

Embodiment 3 of the present invention will be described. In Embodiment 1, the temperature distribution shown in Fig. 5 includes the temperature of the assembled battery 10 at the time of switching of the ignition switch from OFF to ON and the temperature of the assembled battery 10 in the period while the ignition switch is ON. In the present embodiment, only the temperature of an assembled battery 10 at the time of switching of an ignition switch from OFF to ON is used as a temperature distribution (corresponding to the temperature distribution in Fig. 5) for specifying an area.

As described in Embodiment 1, the area can be specified by comparing the temperature distribution at lower temperature levels. Specifically, attention is focused on the temperature distribution of the assembled battery 10 at the time of switching of the ignition switch from OFF to ON. Thus, in the present embodiment, the temperature distribution of the assembled battery 10 at the time of the switching of the ignition switch from OFF to ON is used as information corresponding to the temperature distribution in Fig. 5. In the temperature distribution used in the present embodiment, the horizontal axis represents the temperature of the assembled battery 10 and the vertical axis represents the frequency, similarly to Fig. 5.

In the present embodiment, similarly to Embodiment 1, the area where the assembled battery 10 is used can be specified on the basis of the temperature distribution of the assembled battery 10. The specification of the use area of the assembled battery 10 enables the estimation of the deterioration state of the assembled battery 10.

The temperature of the assembled battery 10 detected by the temperature sensor 12 in the period while the ignition switch is ON can be used for adjusting the temperature of the assembled battery 10. Specifically, when the temperature of the assembled battery 10 rises, a blower can be driven to supply air for cooling to the assembled battery 10 to suppress the temperature rise in the assembled battery 10. On the other hand, when the temperature of the assembled battery 10 drops, air for heating can be supplied to the assembled battery 10 to suppress the temperature drop in the assembled battery 10.

Although Embodiments 1 to 3 have described the assembled battery 10 mounted on the vehicle, the present invention is not limited thereto. The present invention is applicable to any device on which the assembled battery 10 is mounted. Even when the assembled battery 10 is mounted on a device other than the vehicle, the deterioration state of the assembled battery 10 is changed depending on the temperature in the area where the assembled battery 10 is used. Thus, in the device on which the assembled battery 10 is mounted, the use area of the assembled battery 10 can be specified to estimate the deterioration state of the assembled battery 10 similarly to Embodiments 1 to 3.

Although Embodiments 1 to 3 described above employ the assembled battery 10 formed of the plurality of cells, the present invention is not limited thereto. The present invention is applicable when a single cell is used.

## Claims

1. An electric storage system comprising:
an electric storage apparatus connected to a load and performing charge and discharge;
a temperature sensor detecting a temperature of the electric storage apparatus in response to connection of the electric storage apparatus to the load; and
a controller estimating a deterioration state of the electric storage apparatus based on temperature information in a usage environment of the electric storage apparatus,
wherein the controller obtains a temperature distribution of the electric storage apparatus based on an output from the temperature sensor when the electric storage apparatus is connected to the load, and specifies a usage environment of the electric storage apparatus associated with the obtained temperature distribution.

2. The electric storage system according to claim 1, wherein the controller specifies the usage environment of the electric storage apparatus by specifying a temperature distribution substantially matching the temperature distribution obtained on the basis of the output from the temperature sensor, out of temperature distributions of the electric storage apparatus in a plurality of usage environments.

3. The electric storage system according to claim 2, further comprising a current sensor detecting an electric current in charge and discharge of the electric storage apparatus,
wherein the controller specifies the temperature distribution of the electric storage apparatus in the plurality of usage environments in association with a result of detection by the current sensor.

4. The electric storage system according to claim 3, further comprising a memory storing the temperature distribution of the electric storage apparatus in the plurality of usage environments for each result of detection by the current sensor,
wherein the controller uses an output from the current sensor and information stored in the memory to specify the temperature distribution of the electric storage apparatus in the plurality of usage environments in association with the result of detection by the current sensor.

5. The electric storage system according to any one of claims 1 to 4, wherein the controller estimates a lifetime of the electric storage apparatus as the deterioration state.

6. The electric storage system according to claim 5, wherein the controller imposes a restriction on an input/output of the electric storage apparatus when an estimated lifetime of the electric storage apparatus is shorter than a target lifetime.

7. The electric storage system according to claim 5 or 6, wherein the controller relaxes the restriction on the input/output of the electric storage apparatus when the estimated lifetime of the electric storage apparatus is longer than the target lifetime.

8. The electric storage system according to any one of claims 1 to 7, wherein the electric storage apparatus has a plurality of electric storage elements connected electrically in series.

9. The electric storage system according to any one of claims 1 to 8, wherein the electric storage apparatus is mounted on a vehicle and outputs an energy for use in running of the vehicle.

10. The electric storage system according to any one of claims 1 to 9, wherein the temperature distribution of the electric storage apparatus shows a relationship between the temperature of the electric storage apparatus and a frequency of occurrence of each temperature of the electric storage apparatus.

11. A method of estimation comprising:
a first step of detecting a temperature of an electric storage apparatus in response to connection of the electric storage apparatus to a load, the electric storage apparatus performing charge and discharge; and
a second step of obtaining a temperature distribution of the electric storage apparatus based on a result of the detection at the first step when the electric storage apparatus is connected to the load and specifying a usage environment of the electric storage apparatus associated with the obtained temperature distribution; and
a third step of estimating a deterioration state of the electric storage apparatus based on temperature information in the usage environment of the electric storage apparatus specified at the second step.

12. The method of estimation according to claim 11, wherein, at the second step, the usage environment of the electric storage apparatus is specified by specifying a temperature distribution substantially matching the temperature distribution obtained on the basis of the detection result at the first step, out of temperature distributions of the electric storage apparatus in a plurality of usage environments.

13. The method of estimation according to claim 12, further comprising a fourth step of detecting an electric current in charge and discharge of the electric storage apparatus,
wherein, at the seconds step, the temperature distribution of the electric storage apparatus in the plurality of usage environments is specified in association with a result of the detection at the fourth step.

14. The method of estimation according to claim 13, wherein information stored in a memory storing the temperature distribution of the electric storage apparatus in the plurality of usage environments for each result of the detection at the fourth step and the detection result at the fourth step are used to specify the temperature distribution of the electric storage apparatus in the plurality of usage environments in association with the detection result at the fourth step.

15. The method of estimation according to any one of claims 11 to 14, wherein a lifetime of the electric storage apparatus is estimated as the deterioration state at the third step.

16. The method of estimation according to any one of claims 11 to 15, wherein the temperature distribution of the electric storage apparatus shows a relationship between the temperature of the electric storage apparatus and a frequency of occurrence of each temperature of the electric storage apparatus.
